# EUROPEAN PATENT APPLICATION

(11) **EP 4 749 685 A1**
(43) Date of publication of application: **27.05.2026**
(21) Application number: 25159402.4
(22) Date of filing: 21.02.2025
(51) Int. Cl.: H01L 23/40

(54) **POWER MODULE ASSEMBLY AND FIXING DEVICE ADAPTED THERETO**

(30) Priority: 22.11.2024 CN 202411681456
(71) Applicant: Delta Electronics, Inc., Taoyuan City 333 (TW)
(72) Inventor: Chiang, Chun-Liang, 333 Taoyuan City (TW); Chiu, Hung-Nien, 333 Taoyuan City (TW); Lee, Wei-Yi, 333 Taoyuan City (TW); Ou Yang, Jhen, 333 Taoyuan City (TW); Wu, Chun-Han, 333 Taoyuan City (TW); Yang, Chih-Wei, 333 Taoyuan City (TW)
(74) Representative: Uexküll & Stolberg

(57) **Abstract**

A power module assembly (1, 1', 1") includes a power module (10, 10', 10"), a fixing device (20, 20', 20") and at least one fixing element (30, 30', 30"). The power module (10, 10', 10") includes a housing (101, 101', 101") and a protrusion body (110, 110', 110") disposed on the housing (101, 101', 101"). The fixing device (20, 20', 20") is disposed on the protrusion body (110, 110', 110") and includes at least one fixing portion (210, 210', 210"), a first engaging portion (230, 230") and a second engaging portion (230, 230"), and plural connecting portions (220, 220', 220"). The first engaging portion (230, 230") and the second engaging portion (230, 230") are respectively disposed at two opposite sides of the at least one fixing portion (210, 210', 210") for respectively engaging with two opposite sides of the protrusion body (110, 110', 110"). The plural connecting portions (220, 220', 220") are respectively disposed between the at least one fixing portion (210, 210', 210") and the first engaging portion (230, 230") and the at least one fixing portion (210, 210', 210") and the second engaging portion (230, 230"). The at least one fixing element (30, 30', 30") respectively fixes the at least one fixing portion (210, 210', 210"), so as to fix the power module (10, 10', 10") on an external device.

## Description

### FIELD OF THE INVENTION

The present disclosure relates to a power module assembly and a fixing device adapted thereto, and more particularly to a power module assembly and a fixing device adapted thereto which are capable of achieving an effective fixation.

### BACKGROUND OF THE INVENTION

Generally, power modules may generate large amounts of heats during operation, so that it is necessary to dissipating the heats, for example, through contacting with heat dissipation element/device and/or heat dissipation module within the system, so as to improve the reliability and durability thereof.

Accordingly, the fixation between the power module and the heat dissipation element/device/module will directly affect the heat dissipation efficiency and also the performance of the power module. Therefore, how to achieve an effective fixation between the power module and the heat dissipation element/device/module for improving the heat dissipation efficiency has become a critical issue.

### SUMMARY OF THE INVENTION

An object of the present disclosure is to provide a power module assembly and a fixing device adapted thereto for improving the drawbacks in the prior arts.

In accordance with an aspect of the present disclosure, a power module assembly is provided. The power module assembly includes a power module, a fixing device and at least one fixing element. The power module includes a housing and a protrusion body disposed on the housing. The fixing device is disposed on the protrusion body and includes at least one fixing portion, a first engaging portion and a second engaging portion, and a plurality of connecting portions. The first engaging portion and the second engaging portion are respectively disposed at two opposite sides of the at least one fixing portion for respectively engaging with two opposite sides of the protrusion body. The plurality of connecting portions are respectively disposed between the at least one fixing portion and the first engaging portion and the at least one fixing portion and the second engaging portion. The at least one fixing element respectively fixes the at least one fixing portion, so as to fix the power module on an external device.

In an embodiment, when the at least one fixing element respectively fixes the at least one fixing portion, the fixing device applies a force to the power module toward the external device.

In an embodiment, each of the at least one fixing portion comprises a through hole, and each of the least one fixing element penetrates the through hole and fixes on the external device.

In an embodiment, the protrusion body is implemented as a plurality of protrusion bodies, the fixing device is implemented as a plurality of fixing devices, and the plurality of fixing devices are respectively disposed on the plurality of protrusion bodies.

In an embodiment, the protrusion body comprises a plurality of protrusion portions, and an interval space is formed between every two adjacent protrusion portions of the plurality of protrusion portions, wherein the plurality of connecting portions are respectively disposed on the plurality of protrusion portions, and each of the at least one fixing portion is correspondingly disposed in the interval space.

In an embodiment, the first engaging portion and the second engaging portion are respectively engaged with two protrusion portions of the plurality of protrusion portions which are located at two opposite outer sides.

In an embodiment, engaging structures are respectively disposed at two opposite far ends of the two protrusion portions of the plurality of protrusion portions which are located at two opposite outer sides, and engaging elements respectively of the first engaging portion and the second engaging portion of the fixing device are engaged with the engaging structures, so as to assemble the fixing device with the two protrusion portions of the plurality of protrusion portions which are located at two opposite outer sides.

In an embodiment, each of the plurality of protrusion portions comprises an extension portion and a stopping portion, and each of the plurality of connecting portions of the fixing device is disposed at the extension portion of a corresponding protrusion portion of the plurality of protrusion portions and maintained on the extension portion of the corresponding protrusion portion through the stopping portion.

In an embodiment, the protrusion body comprises engaging structures respectively at two opposite sides thereof, and engaging elements respectively of the first engaging portion and the second engaging portion of the fixing device are correspondingly engaged with the engaging structures, so as to assemble the fixing device with the protrusion body.

In an embodiment, the protrusion body comprises an extension portion and a stopping portion, and the plurality of connecting portions are disposed on the extension portion and maintained on the extension portion through the stopping portion.

In an embodiment, the protrusion body comprises at least one through portion, and the at least one fixing element penetrates the at least one through portion and fixes on the external device.

In an embodiment, the protrusion body and the housing are integrally formed as one piece.

In an embodiment, the housing of the power module comprises an upper surface and a lower surface opposite to each other and at least one side surface connecting the upper surface and the lower surface, wherein the lower surface faces the external device, and the protrusion body is protrudently disposed on one of the at least one side surface.

In an embodiment, the at least one fixing portion is at a first plane, the plurality of connecting portions are at a second plane, and a distance between the first plane and the lower surface is less than or equal to a distance between the second plane and the lower surface.

In an embodiment, the power module comprises a plurality of pins protrudently disposed on the upper surface.

In an embodiment, the fixing device comprises at least one supporting element disposed on at least one of the plurality of connecting portions.

In accordance with another aspect of the present disclosure, a fixing device is provided. The fixing device is disposed on a protrusion body of a power module and is fixed by at least one fixing element for fixing the power module to an external device. The fixing device includes at least one fixing portion, a first engaging portion and a second engaging portion, and a plurality of connecting portions. The first engaging portion and the second engaging portion are respectively disposed at two opposite sides of the at least one fixing portion for respectively engaging with two opposite sides of the protrusion body. The plurality of connecting portions are respectively disposed between the at least one fixing portion and the first engaging portion and the at least one fixing portion and the second engaging portion.

In an embodiment, when the at least one fixing element respectively fixes the at least one fixing portion, the fixing device applies a force to the power module toward the external device.

In the power module assembly of the present disclosure, the housing of the power module has the protrusion body additionally disposed thereon for engaging with the fixing device, and the fixing element is further employed to penetrate the fixing device and fix on an external device, such as the heat dissipation device, so that a more stable fixation can be provided between the power module and the external device.

### BRIEF DESCRIPTION OF THE DRAWINGS

The above contents of the present disclosure will become more readily apparent to those ordinarily skilled in the art after reviewing the following detailed description and accompanying drawings, in which:
FIG. 1 is a schematic view showing a power module assembly according to an embodiment of the present disclosure;
FIG. 2 is an exploded schematic view showing the power module assembly according to the embodiment of the present disclosure;
FIG. 3A is a schematic view showing a power module according to an embodiment of the present disclosure;
FIG. 3B is a top view of the power module according to an embodiment of the present disclosure;
FIG. 4A is a schematic view showing a fixing device according to an embodiment of the present disclosure;
FIG. 4B is a top view of the fixing device according to the embodiment of the present disclosure;
FIG. 5 is a sectional view of A-A' plane in FIG. 1;
FIG. 6A is a schematic view showing a power module assembly according to another embodiment of the present disclosure;
FIG. 6B is a schematic view showing a power module assembly according to another embodiment of the present disclosure; and
FIG. 7 is a schematic view showing a power module assembly according to another embodiment of the present disclosure.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

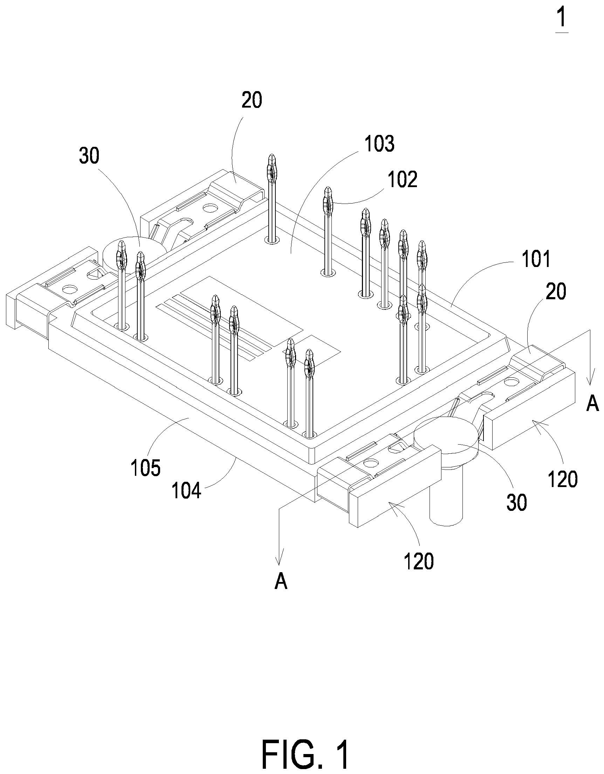

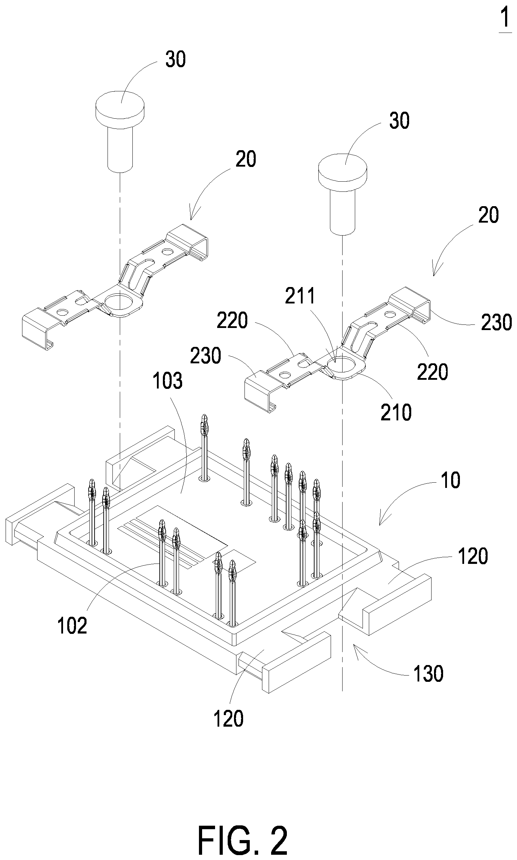

Please refer to FIG. 1 and FIG. 2. FIG. 1 is a schematic view showing a power module assembly according to an embodiment of the present disclosure, and FIG. 2 is an exploded schematic view showing the power module assembly according to the embodiment of the present disclosure. A power module assembly 1 in the present disclosure includes a power module 10, fixing devices 20 and fixing elements 30. The power module 10 and the fixing devices 20 are assembled together and fixed to an external device (not shown), for example, fixed to a heat dissipation element/heat dissipation device or fixed to a heat dissipation module in a system, through the fixing elements 30, so as to achieve the heat dissipation of the power module 10. For example, the power module 10 can be a power module of an onboard charger which is assembled with the fixing devices 20 and then fixed to a housing of the system through the fixing elements 30 for utilizing the cooling module in the system to achieve the heat dissipation thereof. Alternatively, the power module 10 also can be a power module in other system/equipment/apparatus without limitation. In other words, in the power module assembly 1 of the present disclosure, the effective fixation between the power module 10 and the external device is achieved by the cooperation between the fixing devices 20 and the fixing elements 30 which are both externally arranged to the power module 10.

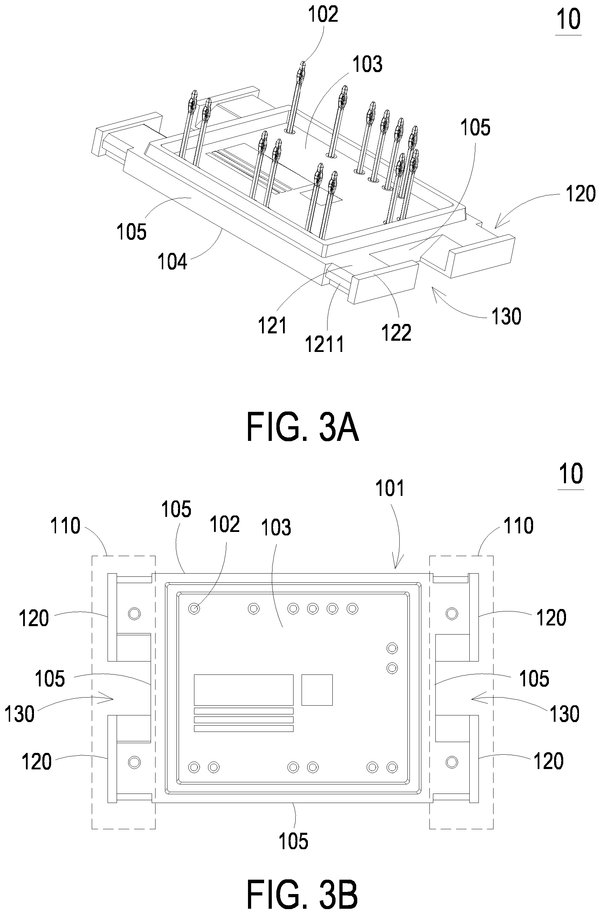

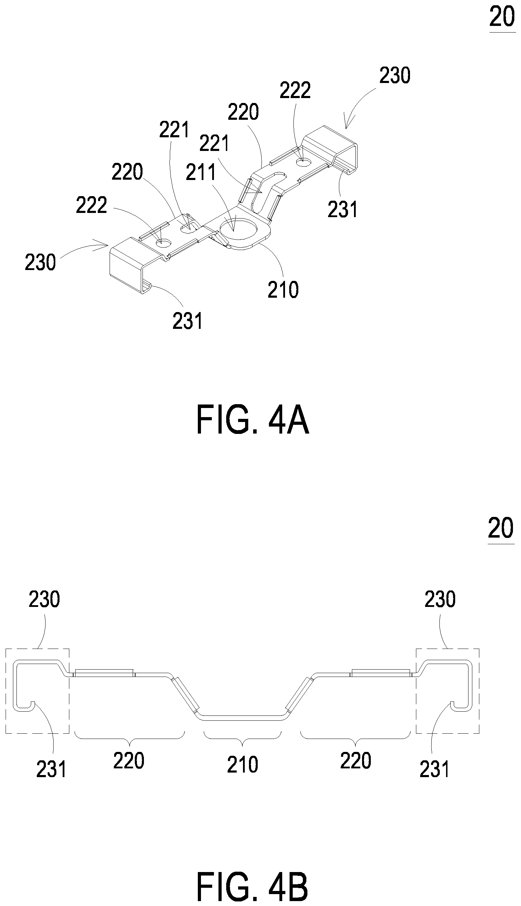

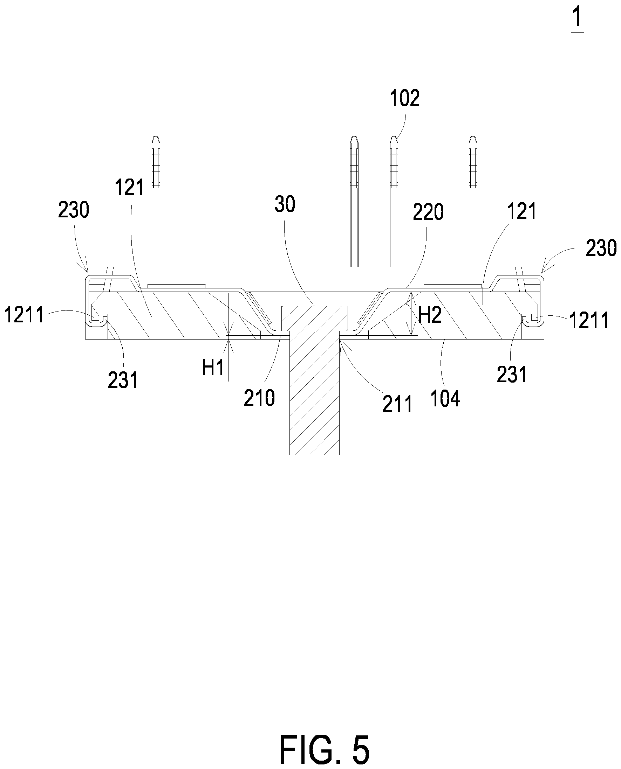

Please refer to FIG. 1 to FIG. 5. FIG. 3A is a schematic view showing a power module according to an embodiment of the present disclosure, FIG. 3B is a top view of the power module according to the embodiment of the present disclosure, FIG. 4A is a schematic view showing a fixing device according to an embodiment of the present disclosure, FIG. 4B is a top view of the fixing device according to the embodiment of the present disclosure, and FIG. 5 is a sectional view of A-A' plane in FIG. 1. The power module 10 includes a housing 101 and pins 102. The housing 101 includes an upper surface 103 and a lower surface 104 which are opposite to each other. The pins 102 are protrudently disposed on the upper surface 103. The lower surface 104 faces to the device for disposing the power module 10 thereon, for example, the lower surface 104 faces the heat dissipation device/module. In this embodiment, the housing 101 is implemented as a rectangular cuboid with four side surfaces 105; in other embodiments, the housing of the power module also can be implemented as other shapes. Therefore, the number of side surfaces can be varied in accordance with practical situations.

In the embodiment of FIG. 1 to FIG. 5, the housing 101 includes two protrusion bodies 110 respectively located on the side surfaces 105 at opposite sides. The protrusion bodies 110 can be integrally formed with the housing 101 as one piece or can be attached to the housing 101, without limitation. The protrusion bodies 110 are used to dispose the fixing devices 20, and the fixing devices 20 are further fixed by the fixing elements 30, so that when the fixing forces between the fixing elements 30 and the underlying device are formed, the power module 10 is also fixed to the underlying device. In order to achieve a balanced fixation and an average force application, it is preferable to arrange the protrusion bodies in a symmetrical manner. The arrangement also can be varied in accordance with practical situations. For example, the power module might be installed in different systems or might be disposed at different locations in a system in which components and modules surrounding thereof are varying, and accordingly, for achieving an effective fixation of the power module, the number, position, size and/or shape of the protrusion body can be varied according to the space in the practical situation, without limitation. For the sake of easily understanding, the following descriptions are based on the protrusion bodies arranged in a symmetrical manner, and one skilled in the art can understand that it is for illustrative purpose only and the scope of the present disclosure is not limited thereto.

In this embodiment, each protrusion body 110 includes a plurality of protrusion portions 120, and between two adjacent protrusion portions 120, an interval space 130 is formed. Each protrusion portion 120 includes an extension portion 121 and a stopping portion 122. The fixing devices 20 are respectively disposed on the protrusion bodies 110. Each fixing device 20 includes a fixing portion 210, connecting portions 220 and engaging portions 230. The fixing portion 210 is correspondingly disposed in the interval space 130 between the protrusion portions 120, the engaging portions 230 are correspondingly engaged with the extension portions 121 for fixing the fixing device 20 on the protrusion body 110, and the connecting portions 220 connect the fixing portion 210 and the engaging portions 230 and are disposed on the extension portions 121. The stopping portion 122 is used to maintain the connecting portion 220 on the extension portion 121 for preventing the fixing device 20 from detaching from the protrusion body 110. Moreover, the fixing portion 210 has a through hole 211 formed thereon for being penetrated by the fixing element 30. Under this configuration, when the fixing element 30 passes through the interval space 130 and penetrates the through hole 211 of the fixing portion 210 to form a fixing force with the underlying device, the fixing force can be transmitted to the power module 10 through the fixing device 20, which contacts with the fixing element 30, thereby achieving the purpose of fixing the power module 10 to the underlying device.

In this embodiment, since two protrusion portions 120 on each side surface 105 are arranged in a symmetric manner, the fixing device 20 also adopts a symmetric structure. Namely, the fixing portion 210 is at the center, the engaging portions 230 are arranged at two sides thereof, and the connecting portions 220 are respectively disposed between the fixing portion 210 and the engaging portions 230. In other embodiments, the respective number and the position relationship of the fixing portion 210, the connecting portions 220 and the engaging portions 230 all can be varied in accordance with the variation of the protrusion body 110, and accordingly, the number of the fixing element 30 also can be varied.

In other words, the fixing device 20 is mainly, through the engaging portions 230 at two ends thereof, engaged with two opposite sides of the protrusion body 110, or with two opposite far ends of plural protrusion portions 120, and the arrangements of the fixing portion 210 and the connecting portions 220 between two engaging portions 230 can be varied in accordance with the variation of the protrusion body 110 or the protrusion portions 120 without limitation. It only needs to ensure that the fixing device 20 can be further fixed to the device under the power module 10 by the fixing element(s) 30.

In some embodiments, the fixing device 20 is made of flexible material, such as flexible metal sheet, flexible plastic sheet, so that a temporary deformation of the flexible material can help to assemble the engaging portion 230 with the extension portion 121. In other embodiments, the protrusion portions 120 are implemented to be detachable from the housing 101 or the stopping portion 122 of the protrusion portion 120 is implemented to be detachable, so that the fixing device 20 can be mounted to the protrusion portions 120, and under this situation, the choices of material for the fixing device 20 are even more.

In order to achieve the fixation with the protrusion portions 120, the engaging portions 230 at two ends of the fixing device 20 are respectively extended to the bottom of the extension portion 121 of each protrusion portion 120. Under this situation, preferably, the bottom of the extension portion 121 is higher than the lower surface 104 for providing the space to accommodate the engaging portion 230, and thus preventing the engaging portion 230 from influencing the flatness of the lower surface 104 for contacting the underlying device. Furthermore, an engaging structure 1211 can be formed on the extension portion 121, and the engaging portion 230 can include an engaging element 231, so that through the mutual engagement between the engaging structure 1211 and the engaging element 231, the fixation effect can be enhanced. For example, the engaging structure 1211 can be implemented as a recess with an opening thereof facing the lower surface 104, and the engaging element 231 can be implemented as a bending section, which can be engaged into the recess, at the end of the engaging portion 230.

The protrusion portions 120 in the protrusion body 110, other than being implemented to separately dispose on the side surface 105, namely, as independent protrusions on the side surface 105, also can be implemented as connected with each other. For example, the protrusion body 110 can have a n-like shape, and when being disposed on the side surface 105, the interval space 130 also can be formed between the protrusion portions 120.

The shape of the fixing device 20 is substantially matched with ups and downs of the protrusion portions 120 and the interval space 130. In this embodiment, the fixing portion 210 in the interval space 130 is implemented to close to the lower surface 104, and the section of the connecting portion 220 that is arranged on the extension portion 121 is substantially parallel to and higher than the plane that the fixing portion 210 is located. That is, if the plane of the fixing portion 210 is the first plane, and the plane of the connecting portion 220 is the second plane, a distance between the first plane and the lower surface 104 is less than a distance between the second plane and the lower surface 104. When the fixing element 30 penetrates the fixing portion 210 and fixes to the underlying device, the downward fixing force generated by the fixing element 30 can be transmitted to the connecting portions 220 through the fixing portion 210 and thus apply to the extension portions 121, as well as the extension portions 121 are engaged with the engaging portions 230, so that the power module 10 can be fixed by the fixing device 20 through the downward force from the fixing elements 30. In other embodiments, the respective planes of the connecting portion 220 and the fixing portion 210 also can be not parallel to each other, it only needs to ensure that the downward force from the fixing element 30 can be transmitted to the power module 10.

In an embodiment, a spacing H1 is left between the fixing portion 210 and the lower surface 104. The spacing H1 provides space for the fixing portion 210 to have slight movements when the fixing element 30 penetrates the through hole 211 and fixes to the underlying device. When the fixing element 30 applies the downward force, the spacing H1 provides the possibility for the fixing portion 210 to move downwardly to further increase the force applied on the extension portions 121 by the connecting portions 220, and thus, increase the overall downward force for fixing the power module 10 to the underlying device, thereby providing a more stable fixation. In another embodiment, the connecting portion 220 includes an adjusting orifice 221, whereby the structural strength of the connecting portion 220 can be adjusted, and the amplitude of deformation that can be produced by the connecting portion 220 also can be increased. For example, a distance H2 between the connecting portion 220 and the fixing portion 210 can therefore be slightly changed as the fixing element 30 applies the downward force, which helps the fixing portion 210 to move downwardly, thereby achieving a more stable fixation. The purpose of arranging the spacing H1 and/or the adjusting orifice 221 is to equip the fixing device 20 a greater deformation capability for improving the fixation effect, and thus, the range of the spacing H1 and the shape, number and position of the adjusting orifice 221 all can be varied in accordance with practical situations without limitation.

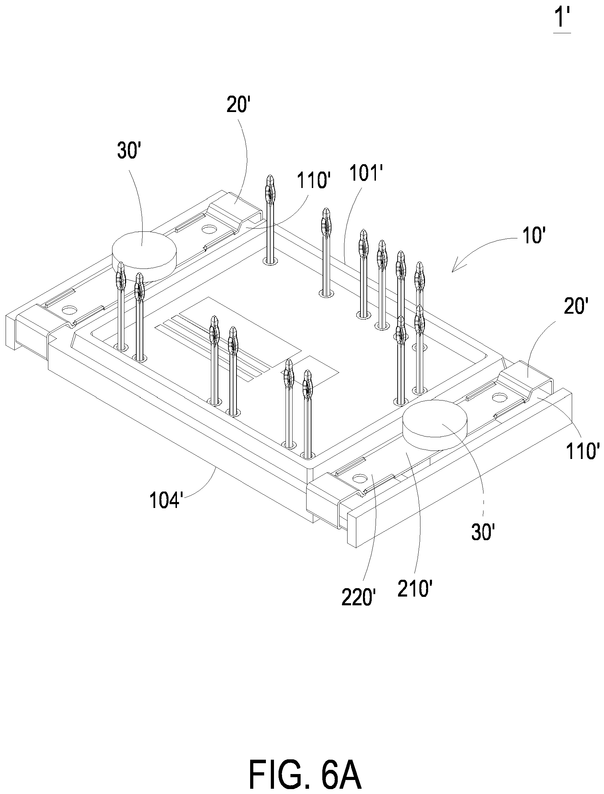

In accordance with another aspect of the present disclosure, the protrusion body also can be implemented to be other type. Please refer to FIG. 6A which is a schematic view showing a power module assembly according to another embodiment of the present disclosure. In this embodiment, the power module assembly 1' includes the power module 10', the fixing devices 20' and the fixing elements 30'. The difference from the embodiment described above is protrusion bodies 110' on the housing 101' are respectively implemented as one single protrusion, and thus, the shape of the fixing device 20' is correspondingly changed for matching with the protrusion body 110'. In other words, in this embodiment, the distance between the first plane where the fixing portion 210' is located and the lower surface 104' is substantially equal to the distance between the second plane where the connecting portion 220' is located and the lower surface 104'. Under this configuration, the protrusion body 110' further includes a through portion (not shown) disposed thereon, so that the fixing element 30' can penetrate the through portion and fix to the underlying device. Similarly, the fixing device 20' includes the through hole disposed thereon corresponding to the through portion for being penetrated by the fixing element 30'. Accordingly, the downward force produced by the fixing element 30' can downwardly fix the power module 10' through the fixing device 20'.

In another embodiment, single protrusion body can have multiple through portions disposed thereon and the fixing device can have multiple through holes corresponding thereto for being penetrated by multiple fixing elements, thereby further increasing the fixing forces with the underlying device. This is especially beneficial to provide balanced fixing forces when the area of the power module is larger.

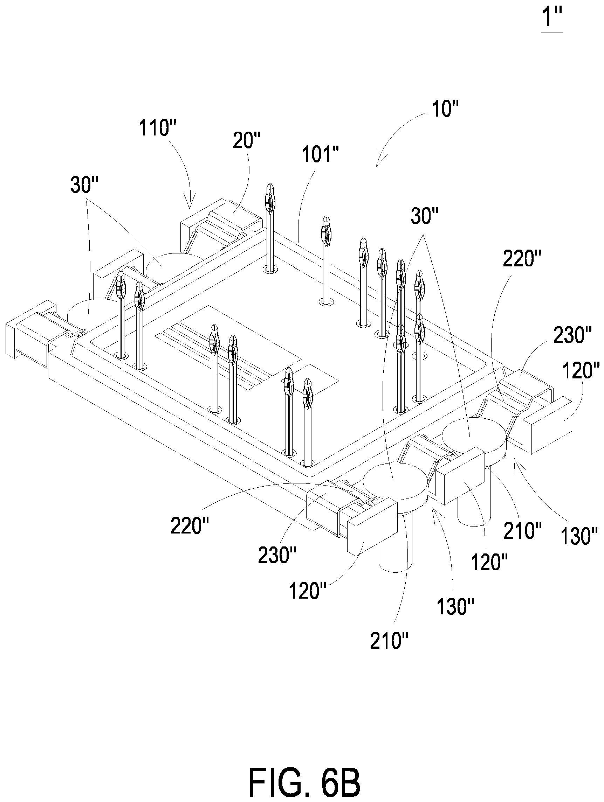

In another embodiment, the protrusion body which is disposed on single side surface can include more than two protrusion portions so as to form plural interval spaces. For example, it can be implemented to include three protrusion portions and two interval spaces, as shown in FIG. 6B. The power module assembly 1" includes the power module 10", the fixing devices 20" and the fixing elements 30". Each protrusion body 110" on the housing 101" respectively includes three protrusion portions 120", so as to form two interval spaces 130". Accordingly, the fixing device 20" includes two fixing portions 210" corresponding to the two interval spaces 130"; three connecting portions 220" respectively disposed on the three protrusion portions 120"; and two engaging portions 230" respectively engaging with two opposite far ends of the three protrusion portions 120". Under this configuration, two fixing elements 30" are employed to penetrate the fixing portions 210" of each fixing device 20", so that the fixing forces with the underlying device can be increased, which is beneficial to provide balanced fixing forces when the area of the power module is larger.

In another embodiment, the embodiment that single side surface has single protrusion disposed thereon and the embodiment that single side surface has the protrusion body including plural protrusion portions disposed thereon can be mixed and used on the same power module. That is, different side surfaces of the power module can have different types of protrusion bodies and/or different number of protrusion portions disposed thereon. Therefore, it can be varied in accordance with practical situations, and not limited by the drawings.

Consequently, as long as the housing has the protrusion body disposed thereon, for example, integrally formed as one piece or attached thereto, the protrusion body and the fixing device are implemented to have matched structures, and the fixing device can be fixed to the underlying device through the fixing element for applying the downward force on the protrusion body and the overall power module, thereby achieving an effective fixation between the power module and the underlying device, all situations thereof fall within the scope of the present disclosure.

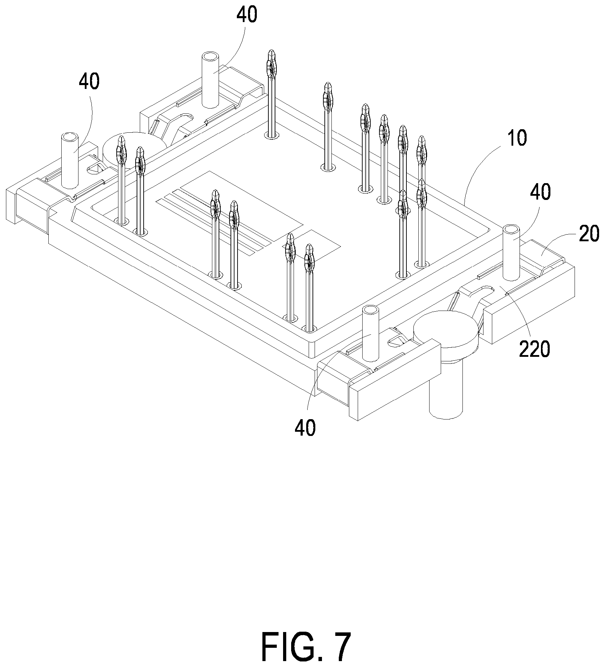

Further, please refer to FIG. 4 and FIG. 7. FIG. 7 is a schematic view showing a power module assembly according to another embodiment of the present disclosure. The fixing device 20 can further have supporting elements 40 disposed thereon, for example, through forming supporting holes 222 on the connecting portions 220 to fix the supporting elements 40. The supporting elements 40 are able to maintain the space above the power module 10 for preventing the power module 10 from being pressed. On the other hand, as needed, the supporting elements 40 also can provide the function of fixing object(s) above the power module 10, for example, for fastening object(s) above. Accordingly, the positions of the supporting holes 222 and the type of the supporting elements 40 all can be varied in accordance with practical situations for achieving the best usage.

In conclusion, through providing the fixing device at the external of the power module, in the power module assembly of the present disclosure, the fixation between the power module and the external device, such as heat dissipation module/device, can become more stable. Further, the fixing device is disposed on the protrusion body, which is externally disposed on the side surface of the housing of the power module, so the numbers, positions, shapes and sizes of both the protrusion body and the fixing device all can be varied in accordance with practical usage situations of the power module for achieving the best fixation effect.

## Claims

1. A power module assembly (1, 1', 1"), **characterized by** comprising:
a power module (10, 10', 10") comprising a housing (101, 101', 101") and a protrusion body (110, 110', 110") disposed on the housing (101, 101', 101");
a fixing device (20, 20', 20") disposed on the protrusion body (110, **110',** 110"), the fixing device (20, 20', 20") comprising:
at least one fixing portion (210, 210', 210");
a first engaging portion (230, 230") and a second engaging portion (230, 230") respectively disposed at two opposite sides of the at least one fixing portion (210, 210', 210") for respectively engaging with two opposite sides of the protrusion body (110, 110', 110"); and
a plurality of connecting portions (220, 220', 220") respectively disposed between the at least one fixing portion (210, 210', 210") and the first engaging portion (230, 230") and the at least one fixing portion (210, 210', 210") and the second engaging portion (230, 230"); and
at least one fixing element (30, 30', 30") respectively fixing the at least one fixing portion (210, 210', 210"), so as to fix the power module (10, 10', 10") on an external device.

2. The power module assembly (1, 1', 1") as claimed in claim 1, wherein when the at least one fixing element (30, 30', 30") respectively fixes the at least one fixing portion (210, 210', 210"), the fixing device (20, 20', 20") applies a force to the power module (10, 10', 10") toward the external device.

3. The power module assembly (1, 1', 1") as claimed in claim 1, wherein each of the at least one fixing portion (210, 210', 210") comprises a through hole (211), and each of the least one fixing element (30, 30', 30") penetrates the through hole (211) and fixes on the external device.

4. The power module assembly (1, 1', 1") as claimed in claim 1, wherein the protrusion body (110, 110', 110") is implemented as a plurality of protrusion bodies (110, 110', 110"), the fixing device (20, 20', 20") is implemented as a plurality of fixing devices (20, 20', 20"), and the plurality of fixing devices (20, 20', 20") are respectively disposed on the plurality of protrusion bodies (110, 110', 110").

5. The power module assembly (1, 1', 1") as claimed in claim 1, wherein the protrusion body (110, 110', 110") comprises a plurality of protrusion portions (120, 120"), and an interval space is formed between every two adjacent protrusion portions (120, 120") of the plurality of protrusion portions (120, 120"), wherein the plurality of connecting portions (220, 220', 220") are respectively disposed on the plurality of protrusion portions (120, 120"), and each of the at least one fixing portion (210, 210', 210") is correspondingly disposed in the interval space.

6. The power module assembly (1, 1', 1") as claimed in claim 5, wherein the first engaging portion (230, 230") and the second engaging portion (230, 230") are respectively engaged with two protrusion portions (120, 120") of the plurality of protrusion portions (120, 120") which are located at two opposite outer sides.

7. The power module assembly (1, 1', 1") as claimed in claim 5, wherein engaging structures (1211) are respectively disposed at two opposite far ends of the two protrusion portions (120, 120") of the plurality of protrusion portions (120, 120") which are located at two opposite outer sides, and engaging elements (231) respectively of the first engaging portion (230, 230") and the second engaging portion (230, 230") of the fixing device (20, 20', 20") are engaged with the engaging structures (1211), so as to assemble the fixing device (20, 20', 20") with the two protrusion portions (120, 120") of the plurality of protrusion portions (120, 120") which are located at two opposite outer sides.

8. The power module assembly (1, 1', 1") as claimed in claim 5, wherein each of the plurality of protrusion portions (120, 120") comprises an extension portion (121) and a stopping portion (122), and each of the plurality of connecting portions (220, 220', 220") of the fixing device (20, 20', 20") is disposed at the extension portion (121) of a corresponding protrusion portion (120, 120") of the plurality of protrusion portions (120, 120") and maintained on the extension portion (121) of the corresponding protrusion portion (120, 120") through the stopping portion (122).

9. The power module assembly (1, 1', 1") as claimed in claim 1, wherein the protrusion body (110, 110', 110") comprises engaging structures (1211) respectively at two opposite sides thereof, and engaging elements (231) respectively of the first engaging portion (230, 230") and the second engaging portion (230, 230") of the fixing device (20, 20', 20") are correspondingly engaged with the engaging structures (1211), so as to assemble the fixing device (20, 20', 20") to the protrusion body (110, 110', 110").

10. The power module assembly (1, 1', 1") as claimed in claim 1, wherein the protrusion body (110, 110', 110") comprises an extension portion (121) and a stopping portion (122), and the plurality of connecting portions (220, 220', 220") are disposed on the extension portion (121) and maintained on the extension portion (121) through the stopping portion (122).

11. The power module assembly (1, 1', 1") as claimed in claim 1, wherein the protrusion body (110, 110', 110") comprises at least one through portion, and the at least one fixing element (30, 30', 30") penetrates the at least one through portion and fixes on the external device.

12. The power module assembly (1, 1', 1") as claimed in claim 1, wherein the protrusion body (110, 110', 110") and the housing (101, 101', 101") are integrally formed as one piece.

13. The power module assembly (1, 1', 1") as claimed in claim 1, wherein the housing (101, 101', 101") of the power module (10, 10', 10") comprises an upper surface (103) and a lower surface (104, 104') opposite to each other and at least one side surface (105) connecting the upper surface (103) and the lower surface (104, 104'), wherein the lower surface (104, 104') faces the external device, and the protrusion body (110, 110', 110") is protrudently disposed on one of the at least one side surface (105).

14. The power module assembly (1, 1', 1") as claimed in claim 13, wherein the at least one fixing portion (210, 210', 210") is at a first plane, the plurality of connecting portions (220, 220', 220") are at a second plane, and a distance between the first plane and the lower surface (104, 104') is less than or equal to a distance between the second plane and the lower surface (104, 104').

15. The power module assembly (1, 1', 1") as claimed in claim 13, wherein the power module (10, 10', 10") comprises a plurality of pins protrudently disposed on the upper surface (103).

16. The power module assembly (1, 1', 1") as claimed in claim 1, wherein the fixing device (20, 20', 20") comprises at least one supporting element (40) disposed on at least one of the plurality of connecting portions (220, 220', 220").

17. A fixing device (20, 20', 20"), wherein the fixing device (20, 20', 20") is disposed on a protrusion body (110, 110', 110") of a power module (10, 10', 10") and is fixed by at least one fixing element (30, 30', 30") for fixing the power module (10, 10', 10") to an external device, the fixing device (20, 20', 20") **characterized by** comprising:
at least one fixing portion (210, 210', 210");
a first engaging portion (230, 230") and a second engaging portion (230, 230") respectively disposed at two opposite sides of the at least one fixing portion (210, 210', 210") for respectively engaging with two opposite sides of the protrusion body (110, 110', 110"); and
a plurality of connecting portions (220, 220', 220") respectively disposed between the at least one fixing portion (210, 210', 210") and the first engaging portion (230, 230") and between the at least one fixing portion (210, 210', 210") and the second engaging portion (230, 230").

18. The fixing device (20, 20', 20") as claimed in claim 17, wherein when the at least one fixing element (30, 30', 30") respectively fixes the at least one fixing portion (210, 210', 210"), the fixing device (20, 20', 20") applies a force to the power module (10, 10', 10") toward the external device.

## Amended claims

### Amended claims in accordance with Rule 137(2) EPC.

1. A power module assembly (1, 1', 1"), comprising:
a power module (10, 10', 10") comprising a housing (101, 101', 101") and a protrusion body (110, 110', 110") disposed on the housing (101, 101', 101"), wherein the protrusion body (110, 110', 110") comprises engaging structures (1211) respectively at two opposite sides thereof;
a fixing device (20, 20', 20") disposed on the protrusion body (110, 110', 110"), the fixing device (20, 20', 20") comprising:
at least one fixing portion (210, 210', 210");
a first engaging portion (230, 230") and a second engaging portion (230, 230") respectively disposed at two opposite sides of the at least one fixing portion (210, 210', 210") for respectively engaging with two opposite sides of the protrusion body (110, 110', 110"), wherein engaging elements (231) respectively of the first engaging portion (230, 230") and the second engaging portion (230, 230") are engaged with the engaging structures (1211); and
a plurality of connecting portions (220, 220', 220") respectively disposed between the at least one fixing portion (210, 210', 210") and the first engaging portion (230, 230") and the at least one fixing portion (210, 210', 210") and the second engaging portion (230, 230") for disposing on at least one outer surface of the protrusion body (110, 110', 110"); and
at least one fixing element (30, 30', 30") respectively fixing the at least one fixing portion (210, 210', 210"), so as to fix the power module (10, 10', 10") on an external device.

2. The power module assembly (1, 1', 1") as claimed in claim 1, wherein when the at least one fixing element (30, 30', 30") respectively fixes the at least one fixing portion (210, 210', 210"), the fixing device (20, 20', 20") applies a force to the power module (10, 10', 10") toward the external device.

3. The power module assembly (1, 1', 1") as claimed in claim 1, wherein each of the at least one fixing portion (210, 210', 210") comprises a through hole (211), and each of the least one fixing element (30, 30', 30") penetrates the through hole (211) and fixes on the external device.

4. The power module assembly (1, 1', 1") as claimed in claim 1, wherein the protrusion body (110, 110', 110") is implemented as a plurality of protrusion bodies (110, 110', 110"), the fixing device (20, 20', 20") is implemented as a plurality of fixing devices (20, 20', 20"), and the plurality of fixing devices (20, 20', 20") are respectively disposed on the plurality of protrusion bodies (110, 110', 110").

5. The power module assembly (1, 1', 1") as claimed in claim 1, wherein the protrusion body (110, 110', 110") comprises a plurality of protrusion portions (120, 120"), and an interval space is formed between every two adjacent protrusion portions (120, 120") of the plurality of protrusion portions (120, 120"), wherein the plurality of connecting portions (220, 220', 220") are respectively disposed on at least one outer surface of each of the plurality of protrusion portions (120, 120"), and each of the at least one fixing portion (210, 210', 210") is correspondingly disposed in the interval space.

6. The power module assembly (1, 1', 1") as claimed in claim 5, wherein the first engaging portion (230, 230") and the second engaging portion (230, 230") are respectively engaged with two protrusion portions (120, 120") of the plurality of protrusion portions (120, 120") which are located at two opposite outer sides.

7. The power module assembly (1, 1', 1") as claimed in claim 5, wherein the engaging structures (1211) are respectively disposed at two opposite far ends of the two protrusion portions (120, 120") of the plurality of protrusion portions (120, 120") which are located at two opposite outer sides, and the engaging elements (231) respectively of the first engaging portion (230, 230") and the second engaging portion (230, 230") of the fixing device (20, 20', 20") are engaged with the engaging structures (1211), so as to connect the fixing device (20, 20', 20") with the two protrusion portions (120, 120") of the plurality of protrusion portions (120, 120") which are located at two opposite outer sides.

8. The power module assembly (1, 1', 1") as claimed in claim 5, wherein each of the plurality of protrusion portions (120, 120") comprises an extension portion (121) and a stopping portion (122), and each of the plurality of connecting portions (220, 220', 220") of the fixing device (20, 20', 20") is disposed at the extension portion (121) of a corresponding protrusion portion (120, 120") of the plurality of protrusion portions (120, 120") and maintained on the extension portion (121) of the corresponding protrusion portion (120, 120") through the stopping portion (122).

9. The power module assembly (1, 1', 1") as claimed in claim 1, wherein the protrusion body (110, 110', 110") comprises an extension portion (121) and a stopping portion (122), and the plurality of connecting portions (220, 220', 220") are disposed on the extension portion (121) and maintained on the extension portion (121) through the stopping portion (122).

10. The power module assembly (1, 1', 1") as claimed in claim 1, wherein the protrusion body (110, 110', 110") comprises at least one through portion, and the at least one fixing element (30, 30', 30") penetrates the at least one through portion and fixes on the external device.

11. The power module assembly (1, 1', 1") as claimed in claim 1, wherein the protrusion body (110, 110', 110") and the housing (101, 101', 101") are integrally formed as one piece.

12. The power module assembly (1, 1', 1") as claimed in claim 1, wherein the housing (101, 101', 101") of the power module (10, 10', 10") comprises an upper surface (103) and a lower surface (104, 104') opposite to each other and at least one side surface (105) connecting the upper surface (103) and the lower surface (104, 104'), wherein the lower surface (104, 104') faces the external device, and the protrusion body (110, 110', 110") is protrudently disposed on one of the at least one side surface (105).

13. The power module assembly (1, 1', 1") as claimed in claim 12, wherein the at least one fixing portion (210, 210', 210") is at a first plane, the plurality of connecting portions (220, 220', 220") are at a second plane, and a distance between the first plane and the lower surface (104, 104') is less than or equal to a distance between the second plane and the lower surface (104, 104').

14. The power module assembly (1, 1', 1") as claimed in claim 12, wherein the power module (10, 10', 10") comprises a plurality of pins protrudently disposed on the upper surface (103).

15. The power module assembly (1, 1', 1") as claimed in claim 1, wherein the fixing device (20, 20', 20") comprises at least one supporting element (40) disposed on at least one of the plurality of connecting portions (220, 220', 220").
